# EUROPEAN PATENT APPLICATION

(11) **EP 4 394 503 A1**
(43) Date of publication of application: **03.07.2024**
(21) Application number: 22217160.5
(22) Date of filing: 29.12.2022
(51) Int. Cl.: G03F 7/00

(54) **MASKING DEVICE AND CONTROLLING METHOD THEREOF**

(71) Applicant: ASML Netherlands B.V., 5500 AH Veldhoven (NL)
(72) Inventor: DE JONG, Edwin, 5500 AH Veldhoven (NL); EVERTS, Frank, 5500 AH Veldhoven (NL)
(74) Representative: ASML Netherlands B.V.

(57) **Abstract**

Disclosed is a method for controlling an exposure dose at a substrate utilizing a masking device, which comprises a first blade and a second blade. The method comprises providing radiation pulses at the masking device for exposing the substrate, exposing an exposure area at the substrate by moving the first blade in a first direction relative to a slit center and by moving the second blade in a second direction, with the second direction being opposite to the first direction, keeping an amount of radiation received at the exposure area constant, and wherein moving the first and second blade is defined by a velocity profile of a substrate support supporting the substrate.

## Description

### FIELD

The present invention relates to an apparatus and a method for controlling an exposure dose. Especially it relates to a masking device and a controlling method thereof, the masking device may be arranged in an illumination system. The illumination system, comprising the masking device, may form part of a lithographic apparatus to control the exposure dose at a substrate, wherein the substrate is exposed at a non-constant scan velocity.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask or reticle ) supported by a mask support onto a layer of radiation-sensitive material (resist) provided on a substrate (e.g., a wafer). A substrate support (e.g., a wafer table or wafer holder) constructed to hold a substrate (e.g., a resist coated wafer) can be moved accurately, e.g., so as to position different target portions in the path of a radiation beam at a focused and aligned position, herewith to project the pattern on the substrate.

As semiconductor manufacturing processes continue to advance, the dimensions of circuit elements have continually been reduced while the substrate throughput is increased. This provides more demanding constrains to lithographic systems. With increasing substrate throughput, the exposure time per target area reduces. As the total dose at the target area needs to remain constant (for proper exposure of the resist), the radiation flux needs to be adapted. Control of the dose is typically arranged by controlling the number of radiation pulses, the pulse repetition rate, and or the radiation pulse intensity directly at the radiation system (e.g., laser system).

Typically the exposure radiation is provided via a slit that scans over the substrate surface. The dose at the substrate is governed by the actual velocity of the substrate support that supports the substrate and the exposure area at the substrate, so-called slit. The slit is defined by a shape of the opening formed by shielding means, e.g., a masking device comprising masking blades, arranged near the reticle (US2005012913). Especially, the positions of the masking blades in the scan direction control the illumination area during an exposure cycle or exposure period. Before an exposure of a target area, the masking blades may be set such that no opening is formed (i.e., the slit is closed), in order to avoid unintended exposure of the substrate. To enable exposure of a target area, a first masking blade moves linearly away from a second masking blade (opposite to the first masking blade at a fixed position) and opens the shielding means till a maximum slit area is reached. Herewith, the system is ready for exposing the target area. Exposure of target areas are typically performed at a constant velocity of the support stage. The first and second masking blades are arranged to move synchronously with the patterning device, such that the distance between both blades is kept constant during the exposure, for example, as disclosed in US2005157285A1. Thus, the shape of the opening of the shielding means is kept constant for a certain period (i.e., the relative positions of the masking blades are kept constant). After completion of exposing the target area, the second masking blade starts moving linearly towards the first masking blade to close the opening at the end of the target area.

In order to achieve a higher substrate throughput of lithographic systems, without the need of excessive high accelerations and velocities of the mask support and substrate support, substrate exposures are performed at non-constant velocity, as is disclosed, for example, in US678839B2. This means that not only the target area is exposed when the substrate support moves with constant velocity, the target area is also exposed during the acceleration and the deceleration of the substrate support (before and after the exposure period at constant velocity of the substrate support, respectively). To provide a sufficient dose at the target area, the time interval between successive light pulses (from an excimer laser, for example) is inversely proportional to the velocity of the substrate support. This means that the laser pulse rate is adapted to the substrate support velocity, even during acceleration and deceleration of the substrate support. Controlling the exposure dose by varying the laser output (or the output of the radiation system) in response to the velocity of the substrate support may result in instabilities or undesired fluctuations at the laser (or radiation system). As a result, the exposure dose at the substrate may not be at the required level for at least a portion of the target area, which may result in non-yielding dies.

### SUMMARY

According to a first aspect of the present disclosure there is provided a method for controlling an exposure dose at a substrate utilizing a masking device, which comprises a first blade and a second blade. The method comprises providing radiation pulses at the masking device for exposing the substrate, exposing an exposure area at the substrate by moving the first blade in a first direction relative to a slit center and by moving the second blade in a second direction, with the second direction being opposite to the first direction, keeping an amount of radiation received at the exposure area constant, and wherein moving the first and second blade is defined by a velocity profile of a substrate support supporting the substrate.

Controlling the movement of the blades in response to the velocity profile of the substrate support and or mask support, provides means to control of the radiation dose at the substrate without disturbing the radiation system. Hence, the radiation system is kept stable even during substrate exposures with variable velocity of the supports.

During exposure of the substrate, the velocity profile may comprise a non-constant velocity of the substrate support and or mask support. Exposing the substrate by a scanning exposure while the substrate support moves with a non-constant velocity, i.e., the support accelerates or decelerates, may be beneficial in view of substrate throughput. In addition, lower accelerations and decelerations may be used during the scanning exposure.

The velocity profile may comprise a sinusoidal velocity profile. Such a profile may introduce less mechanical disturbances to the lithographic system.

In addition, the amount of radiation can be controlled by an exposure control metric, wherein the exposure control metric is the number of pulses in the slit (Nₛₗᵢₜ) or radiation dose.

The method according to the first aspect is particularly beneficial for use in a control unit. The control unit may comprise means to set positions of masking blades that are arranged in a masking device. Herewith, the control unit is operable to perform the method of controlling an exposure dose at a substrate.

According to a second aspect of the present disclosure there is provided a masking device for selectively shielding parts of a patterning device from a radiation beam. The masking device comprises a plurality of masking blades that are mechanically uncoupled with respect to one another. A control unit is arranged to control a position of each of the plurality of masking blades and wherein the position of at least two of the plurality of masing blades is defined by a velocity profile of a substrate support supporting a substrate.

During exposure of the substrate, the velocity profile may comprise a non-constant velocity of the substrate support and or mask support. The velocity profile may comprise a sinusoidal velocity profile.

The masking device according to the second aspect is particularly beneficial for use in an illumination system. The illumination system may be part of a lithographic apparatus.

According to a third aspect of the present disclosure there is provided a method for controlling masking blade positions of a masking device. The method comprises: receiving a first input at a control unit, the first input comprising information of a velocity profile of a mask support and/or substrate support to be used during an exposure, receiving a second input at the control unit, the second input being an exposure control metric, determining position set-points of masking blades during the exposure, and moving the masking blades to the determined position set-points.

As the exposure control metric, the number of pulses in the slit (Nₛₗᵢₜ) or radiation dose may be used.

The method for controlling masking blade positions, may receive a signal at the control unit masking corresponding to blade positions. The signal being used as a feedforward or a feedback signal.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic illustration of a part of the lithographic apparatus depicted in Fig. 1 showing masking blades;
- Figure 3A depicts an exploded view of a masking device according to an embodiment of the present disclosure that may form part of the lithographic apparatus depicted in Fig. 1;
- Figure 3B depicts a schematic three dimensional overview of a masking device according to an embodiment of the present disclosure that may form part of the lithographic apparatus depicted in Fig. 1 illustrating the opening between the blades;
- Figure 4 illustrates the masking blade positions as a function of time during a conventional exposure of a target area;
- Figure 5 depicts a schematic front-side view of the masking device;
- Figure 6A depicts velocity profiles of a mask support and a substrate support as a function of time;
- Figure 6B illustrates the masking blade positions at different moments during an exposure of a target area with velocity profiles of Figure 6A, according to an embodiment of the invention; and
- Figure 7 illustrates a schematic representation of a method of controlling a masking device according an embodiment of the invention.

### DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm) and EUV (extreme ultra-violet radiation, e.g., having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The Cartesian coordinate system is not limiting the invention and is used for clarification only.

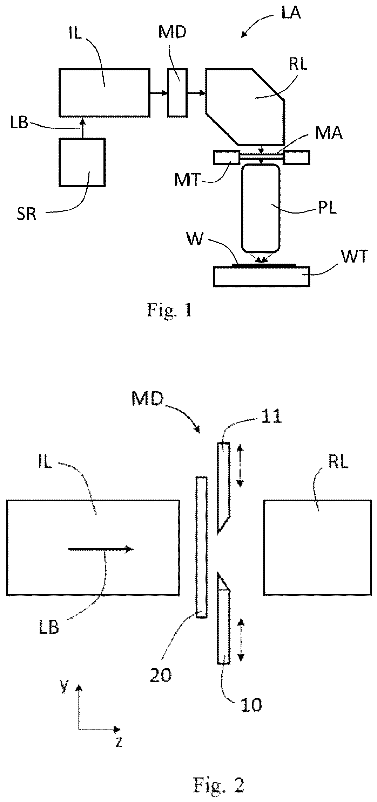

Figure 1 schematically depicts a lithographic apparatus LA. The lithographic apparatus LA includes an illumination system (also referred to as illuminator) IL configured to condition a radiation or light beam LB (e.g., UV radiation, DUV radiation or EUV radiation), a mask support (e.g., a mask table) MT constructed to support a patterning device (e.g., a mask) MA and connected to a first positioner configured to accurately position the patterning device MA in accordance with certain parameters, a substrate support (e.g., a wafer table) WT constructed to hold a substrate (e.g., a resist coated wafer) W. A second positioner configured to accurately position the substrate support in accordance with certain parameters may be arranged. A projection lens system (e.g., a refractive projection lens system) PL configured to project a pattern imparted to the radiation beam LB by patterning device MA (a patterned projection beam) onto a target portion (e.g., comprising one or more dies) of the substrate W.

In operation, the illumination system IL receives a radiation beam from a radiation source SR, e.g., via a beam delivery system. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam LB to have a desired spatial and angular intensity distribution in its cross section at a plane of the patterning device MA.

The term "projection lens system" PL used herein should be broadly interpreted as encompassing various types of projection systems, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PL.

The lithographic apparatus LA may be of a type wherein at least a portion of the substrate may be covered by a liquid having a relatively high refractive index, e.g., water, so as to fill a space between the projection system PL and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PL or a property of the radiation beam LB. The measurement stage may hold multiple sensors. The cleaning device may be arranged to clean part of the lithographic apparatus, for example a part of the projection system PL or a part of a system that provides the immersion liquid. The measurement stage may move beneath the projection system PL when the substrate support WT is away from the projection system PL.

In operation, the radiation beam LB is incident on the patterning device (or mask) MA which is held on the mask support MT, and is patterned by the pattern (design layout) present on patterning device MA. Having traversed the mask MA, the radiation beam LB passes through the projection system PL, which focuses the beam onto a target portion of the substrate W. With the aid of the second positioner and a position measurement system, the substrate support WT can be moved accurately, e.g., so as to position different target portions in the path of the radiation beam LB at a focused and aligned position. Similarly, the first positioner and possibly another position sensor (which is not explicitly depicted in Figure 1) may be used to accurately position the patterning device MA with respect to the path of the radiation beam LB. Patterning device MA and substrate W may be aligned using mask alignment marks and substrate alignment marks. Although the substrate alignment marks occupy dedicated target portions, they may be located in spaces between target portions. Substrate alignment marks are known as scribe-lane alignment marks when these are located between the target portions.

A masking device MD is provided for selectively shielding parts of the patterning device MA from the radiation beam LB. In other embodiments, not illustrated by Fig. 1, the masking device MD may be provided to selectively shield parts of the patterned projection beam. As is illustrated in Fig. 1, relay optics (or relay lens) RL is provided for projecting the radiation that passes through the masking device to the patterning device MA.

Figure 2 shows a cross section in the yz-plane of part of the lithographic apparatus LA, as shown in Figure 1. The masking device MD according to an embodiment of the invention is illustrated schematically. The masking device MD comprises a first masking structure and a second masking structure. The masking structures may be plates or blades or other constructions suitable for selectively obscuring (at least partially) a location at which the patterning device, when in use, is located. That is, a provided radiation beam may be obstructed by the masking structures. The masking device MD preferably comprises masking blades 10, 11, 20, 21, which are arranged to form two sets of blades: the X-blades 20, 21 and the Y-blades 10, 11. The two sets of blades are mechanically uncoupled with respect to one another. That is to say, that the blades are mounted in such a manner that a vibration generated in either an X- or a Y-blade is not transmitted to a Y- or an X-blade, and vice versa.

The masking blades 10, 11, 20, 21 may also be considered as being plates or other constructions suitable for obscuring. According to one embodiment of the invention, the Y-blades 10 and 11 are driven (i.e., operated to move) in y-direction during a substrate exposure, while the X-blades 20 and 21 are stationary during exposure. However, the invention is not limited in this respect and the Y-blades may be stationary. That is, the X-blades 20, 21 may be moveable while the Y-blades 10, 11 are stationary. The blades which move during scanning, hereinafter referred to as the Y-blades for convenience, are controlled by software and electronics and their positions may be adjusted by means of actuators. It is noted that the X-blades are similarly controlled with software and electronics (and actuators). It is common that the Y-blades move together at a defined distance apart in the y-direction, which corresponds with a scanning direction, i.e., a direction in which the mask table/holder MT and the substrate table/holder WT are moved during a scanning exposure. The moving blades are controlled to move according to a desired scanning profile or trajectory.

The blades may be set such that there is a predetermined distance between the X-blades 20, 21 and between the Y-blades 10, 11. Conventionally, the Y-blades 10, 11 are arranged to be moveable during scanning, and the X-blades 20, 21, although moveable, are generally arranged to be stationary during scanning. If the X-blades 20, 21 are to be moved, this generally takes place in between two scans (exposure periods). For static exposures the X-blades may be moved between exposures. For scanning exposures, Y-blades 10, 11 are in particular arranged to perform additional movements which allows scanning of the patterning device MA by the radiation beam LB.

With reference to figure 2, the masking device MD and, in particular, features of the masking blades 10, 11, 20 and their arrangements with respect to each other and other components of the lithographic apparatus are described in further detail in US2005157285A1, incorporated herein by reference.

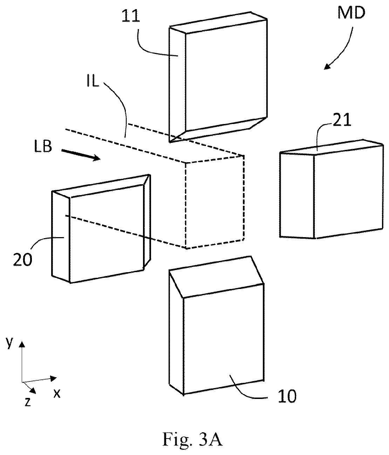

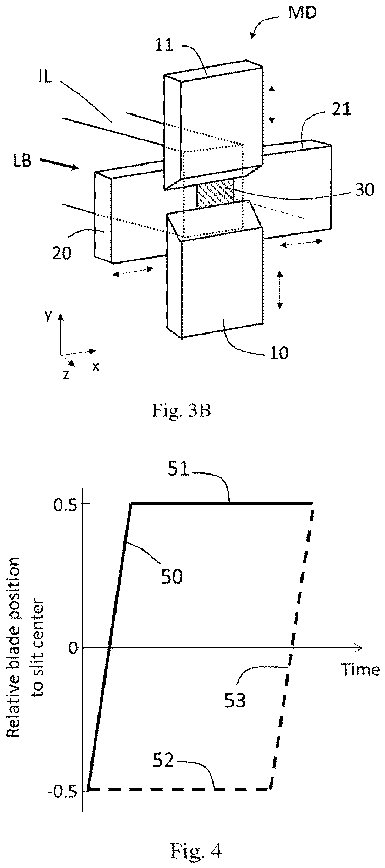

Figures 3A and 3B depict, respectively, an exploded view and a schematic three dimensional overview of a masking device MD of the lithographic apparatus LA as depicted in Figure 1. These figures provide an example of an arrangement of the blades 10, 11, 20, 21 with respect to each other. The double headed arrows illustrate the movement direction of each blade.

As illustrated by Figure 3B, the blades 10, 11, 20, 21 can be set such that an opening 30 is formed between the blades. By means of the opening 30, a portion of the radiation beam LB that is provided via the illuminator IL can pass the masking device MD towards the relay lens RL. The dimensions of the radiation passage area 30, which is defined by the opening between the blades, determine what is referred to as the scanning slit shape. By controlling the positions of the blades, the size of the opening 30 (or passage area) is controlled. Herewith, the amount of radiation passing through the masking device MD to interact with the patterning device MA can be controlled and defined. In addition, the position of the opening 30 is defined by each blade position. A controller may be used to set the blade positions.

Figure 4 illustrates blade positions relative to a center of the slit (opening) 30 during a conventional exposure cycle of a target area at a substrate. The line, indicated by reference numbers 50 and 51, illustrates the position of a first blade (first Y-blade) 11 as a function of time. The dotted line, indicated by reference numbers 52 and 53, illustrates the position of a second blade (second Y-blade) 10 as a function of time. At start of the exposure cycle both blades are at the same y-position, which is illustrated by the crossing of the line and the dotted line (at the bottom left of the graph). This means that before the exposure cycle begins, the blades are positioned such to prevent any radiation impinging on the patterning device MA. At the beginning of the exposure cycle the first blade 11 moves to a defined distance from the second blade 10, which is illustrated by the first part of the line 50, to create the opening 30. When the opening 30 is formed (at start of line with reference 51), the actual exposure is performed. At the end of the exposure (end of dotted line 52) the second blade (second Y-blade) 10 in particular, moves into a position (towards the first blade 11) at which radiation is prevented from impinging on the patterning device MA, as illustrated by the dotted line 53. Hence, at the end of the exposure cycle the opening 30 closes such that no radiation impinges on the patterning device MA.

During conventional exposures, the Y-blades 10, 11 remain at a constant distance from each other (i.e., constant slit width), as is illustrated by the line 51 and dotted line 52 of Figure 4. Herewith, the size of the area at which the radiation impinges the patterning device is kept constant. Note: the patterning device MA moves at a predetermined constant scanning speed while being exposed by the radiation beam LB that passed through the opening between the blades 10, 11, 20, 21.

In order to achieve a higher throughput, the velocity (or scan speed) of the mask support MT and the substrate support WT during exposures needs to be increased. Consequently, the acceleration and the required power to achieve those accelerations need to be increased significantly to achieve a constant high speed during exposures. As a side effect, the wafer stage trajectory might also excite undesired vibrations in the system. In order to minimize these vibrations, abrupt changes in accelerations and decelerations need to be avoided. This may be obtained by a velocity profile of the stages MT, WT being a continuous or smooth profile (e.g., curved profile). Such a velocity profile may be a non-constant velocity. As disclosed in, for example, US5995203A, it is possible to perform substrate exposures during acceleration and deceleration of the stages. The velocity of the mask support MT and the substrate support WT may be described as a sinusoidal curve without a constant velocity zone. It is noticed that similar velocity profiles comprising a constant velocity zone may be used. For these exposure settings, opening and closing the blades 10, 11 (as explained above) is done at an increased acceleration and speed of the blades. This may introduce additional vibrations or disturbances.

Radiation dose control is typically done by means of numerous (in-line) radiation detectors, uniformity corrections using gray filters, or attenuation fingers, etc. The aim of dose control is to have a consistent amount of energy uniformly provided on the substrate W. For radiation dose control, a varying scan speed (or velocity of the mask support MT and substrate support WT) at a constant radiation power and attenuation results in a radiation dose variation in field and or on-die at the substrate W, which is not desired.

With exposures performed at non-constant stage velocities, the radiation dose received at the exposed area will vary over the area. That is, the radiation dose received by the exposed area depends on the actual stage velocity. This means that with a constant radiation dose provided by the radiation source SR, a first area exposed at a relatively low stage velocity receives a higher dose than a second area exposed at a relatively high stage velocity. Thus, the introducing of a non-uniform velocity profile without any countermeasure will result in a radiation dose change at substrate level that is inversely proportional to the stage velocity.

Variation of radiation dose over an exposure area may be prevented or minimized by adapting the amount of radiation provided by the radiation source SR to the velocity of the stages MT, WT. Adapting the radiation amount can be done by controlling the radiation source output. For example, the amount of radiation can be adjusted by modulating the radiation power, by modulating the intervals between radiation pulses (e.g., laser pulses), or by a combination thereof, as disclosed in US5995203A. The control can be provided by a feedback control loop or by a feedforward control loop. In general, the radiation output of the radiation source SR is synchronized with the velocity of the stages MT, WT.

The inventors have recognized that modulating the radiation source SR in response to the stage velocities, which may require a relatively large dynamic range of the radiation source SR in terms of output power and pulse regulation, may cause instabilities at the radiation source SR. Instabilities may result in an uncontrolled variation in energy, wavelength, and/or bandwidth of the radiation beam. For some source types, for example excimer lasers, the performance is only defined for a constant repetition rate of the radiation pulses. It would be preferred to minimize modulation of the radiation source to ensure the performance of the radiation source SR.

According to an embodiment of current invention, control of amount of radiation impinging on the patterning device MA, and herewith the amount of radiation used to expose the substrate W, is provided by controlling the amount of radiation passing the masking device MD. More specifically, the radiation dose control is provided by means of the first and second Y-blades 10, 11 in response to the velocity of the mask support MT and/or substrate support WT during a scanning exposure of the substrate W.

The amount of radiation that reaches the exposure area at the substrate is obviously limited by the blades 10, 11, 20, 21, as also explained above. By changing the Y-blade 10, 11 insertion in dependence of field position during a scanning exposure (e.g., field position of the exposed area at the substrate W and or patterning device MA), or a moment of the exposure cycle, the opening 30 can be manipulated in such a manner that the radiation dose is controlled. Thus, the Y-blades move as a function of the velocity profile of the mask support MT and/or substrate support WT.

According to an embodiment of the invention, there is provided a method for controlling a masking device that determines and sets the positions of the Y-blades 10, 11 as a function of time (within the exposure cycle) whereby the control method aims to keep the number of radiation pulses in the slit constant. The number of pulses in the slit is referred as Nₛₗᵢₜ. This metric indicates the number of radiation pulses that each 'pixel' at the substrate receives. The higher the Nₛₗᵢₜ value is, the more pulse-averaging occurs during a scanning exposure. This may result in a better dose performance at the exposed area on the substrate W.

According to another embodiment of the invention, there is provided a method for controlling a masking device that determines and sets the positions of the Y-blades 10, 11 as a function of time (within the exposure cycle), whereby the control method is set to keep the radiation dose in the slit constant.

As said both control methods, using either Nₛₗᵢₜ or dose as an exposure control metric, make use of the Y-blades 10, 11 of the masking device MD. This results in a non-constant shape or size of the opening 30 during the exposure cycle, especially during the exposure of the substrate W, which will be explained in more detail next.

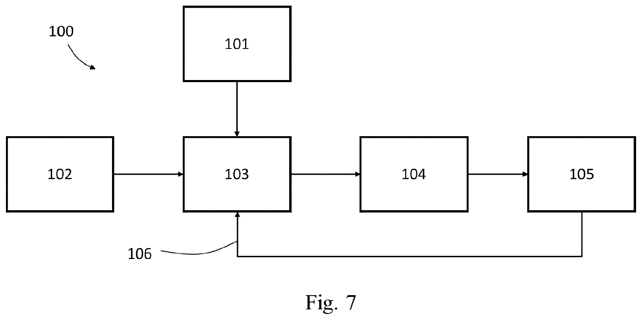

Figure 7 schematically illustrates a method of controlling 100 a masking device according an embodiment of current invention. A controller (or control unit) 103 is arranged to receive a first input 101 comprising information of a velocity profile of a mask support MT and/or substrate support WT to be used during an exposure (exposure cycle). Based on the first input 101, set-points of the blades 10, 11, 20, 21 are defined. As said, either Nₛₗᵢₜ or dose may be used as an exposure control metric. This exposure control metric is received or provided via a second input 102. Based on the received first input 101 and second input 102, the control unit 103 calculates / determines set-points of the blades during the exposure. The set-points may be stored in a memory (e.g., in the form of a look-up table). The control unit 103 instructs one or more actuators 104 by providing a signal (a voltage or a current signal) to set or to move the blades 105 (10, 11) of the masking device MD to the desired (calculated / determined) positions. As the mask support MT and the substrate support WT (also referred as the stages) are moving constantly during a scanning exposure, especially during a scanning exposure with a non-velocity profile, the controller 103 continuously instructs the actuators 104 to synchronize the movement of the Y-blades 10, 11 with the movement of the stages and their velocity profile (first input 101).

Each blade may be connected to at least one actuator.

According to a further embodiment of method of controlling the masking device 100, the control unit 103 may further receive a blade position signal 106. The blade position signal 106 comprises information of the actual position of the blades 105, which may be used for the calculation / determination of the set-points of the blades during the exposure. The blade position signal 106 may be used as a feedforward or a feedback signal. The blade position information may be provided by one or more position sensors provided at the blades 105. These sensors may be electro-mechanical, magnetic, inductive, capacitive, photoelectric, and/or ultrasonic sensors.

Note: the first signal 101 may comprise position information of the stages (mask support MT, substrate support WT) to ensure that the positions of the Y-blades 10, 11 is synchronized with the stage positions. The controller may use stage position information, as received via the first input, and the blade position information, as received via the blade position signal 106, to set and to control the blades 105 via instructions send to the actuators 104.

The methods for controlling the masking device may use or comprise a controller (or control unit) to define and to control the position settings and movements of the masking blades 10, 11, 20, 21. The controller may receive one or more signals that correspond to a velocity of the mask support MT and/or the substrate stage. The one or more signals may be provided by one or more stage controllers.

In addition, a radiation detector may be provided downstream the masking device MD to measure and to monitor the radiation dose as well as the radiation pulse rate passing the masking device MD. The radiation detector may be arranged to provide a detector signal to the controller, wherein the detector signal comprises information about the measured radiation dose and or radiation pulse rate.

One or more radiation detectors may be provided. The one or more radiation detectors may be arranged at the relay optics RL, the mask support MT, the projection system PL, and/or the substrate support WT. Each radiation detector may provide a signal to the controller. Signals corresponding to an amount of radiation dose measured by the one or more radiation detectors may be provided as a third input to the control unit 103 (not illustrated in figure 7).

In an embodiment, the method comprises adjusting radiation characteristics of a radiation source. The radiation characteristics may comprise pulse length, pulse energy, and pulse repetition rate.

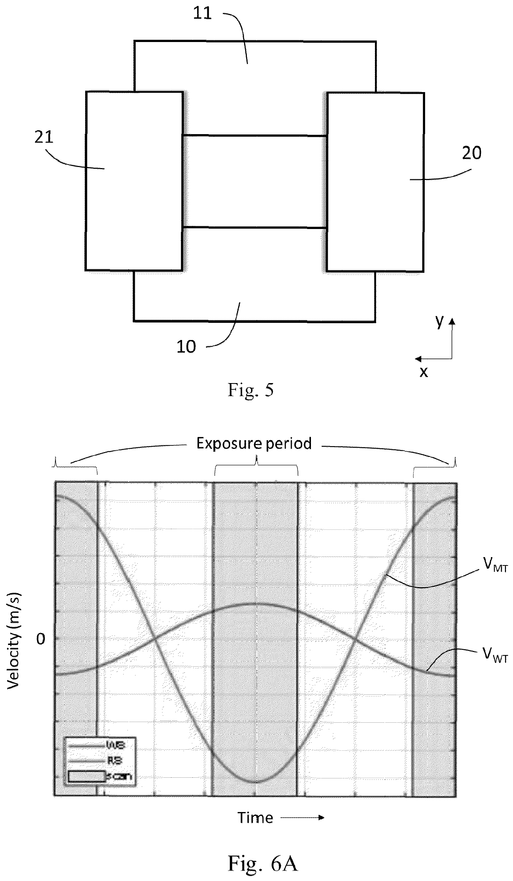

The masking blades 10, 11, 20, 21 of the masking device MD are schematically illustrated from a different perspective in Figure 5. The perspective is, for example, at the path of the radiation beam LB in the illuminator IL (for example as illustrated in Figure 3B).

Figure 6A depicts a velocity profile of a mask support MT and a substrate support WT that may enable a high substrate (wafer) throughput of lithographic systems, without the need of excessive high accelerations and velocities of the mask support (mask support velocity V_{MT}) and substrate support (substrate support velocity V_{WT}). The substrate exposures are performed with non-constant (or non-uniform) velocity of both stages (mask support MT and substrate support WT) during a exposure period as is indicated by grey-filled areas in the graph. Although in this example a sinusoidal velocity profile is presented, other velocity profiles deviating from a sine curve may be used for the same purpose. It would be appreciated by the skilled person that the invention is not limited to sinusoidal velocity profiles of the mask support velocity V_{MT} and the substrate velocity V_{WT}. Note: for a 1:4 magnification exposure system, the velocity of the mask support MT is four time larger than the velocity of the substrate support WT.

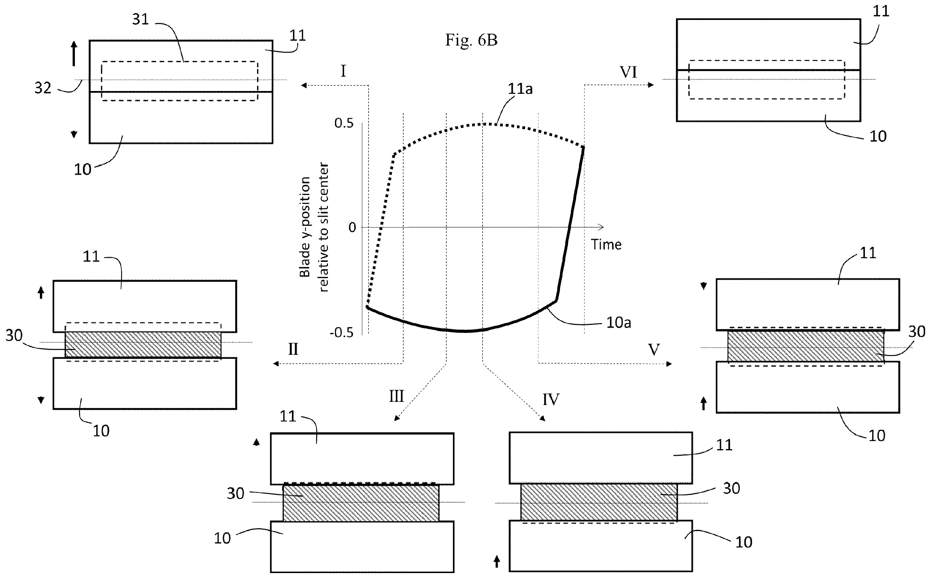

Figure 6B depicts the masking blade positions at different moments during an exposure of a target area while both the mask support MT and the substrate support WT follow a sinusoidal velocity profile (Figure 6A), according to an embodiment of the invention. The position of the first blade 11 and second blade 10 as a function of time is illustrated by a dotted trajectory 11a and a line trajectory 10a, respectively, during an exposure period (e.g., central grey-filled area of Figure 6A). The insets show the positions of both blades during the exposure period, using a similar perspective as illustrated in Figure 5.

With reference to Figure 6A and 6B, the trajectories of both blades with respect to the slit center are plotted as a function of time. The insets next to the graph in Figure 6B provide more insights to the blade positions and movements during an exposure using a non-constant velocity profile as depicted in Figure 6A:
I - At start of the exposure period (or exposure cycle), both Y-blades 10, 11 are positioned such that there is no opening between the Y-blades. The location of the slit area 30 is illustrated by the dashed rectangle 31 (maximum slit area), whereas the center of the slit area 32 is indicated by the dotted line. By moving the first blade 11 upwards, as indicated by the upward arrow, and moving the second blade 10 downwards, as indicated by the downward arrow, the opening 30 is obtained. Thus, the Y-blades 10, 11 move away from each other.
II - The mask support and substrate support continue to increase in velocity. The opening 30 becomes larger as the first blade 11 continues moving upwards and further away from the slit center 32 (though at a lower velocity), and the second blade 10 continues moving downwards (also away from the slit center).
III and IV - Halfway the exposure period, the stages approach their maximum velocity. Before the stages are at their maximum velocity (decrease of the acceleration) the second blade 10 is at its end position with respect to the slit center as indicated by III. After the stages have reached their maximum velocity, the stages start to decelerate and the velocity decreases. The first blade 11 reaches its end position with respect to the slit center as indicated by IV in Figure 6B. At this time window, the opening 30 (slit area) is at its maximum width.
V - At a later moment in the exposure period, the stages continue to decelerate (decrease of the stage velocities). First and second blades move towards the slit center 32 and relatively towards each other.
VI - At the end of the exposure period, the both first blade 11 and second blade 10 are positioned such that there is no opening between the both blades 10, 11. No radiation passes the masking device MD anymore.

The trajectories of the Y-blades, as illustrated by the line 10a and the dotted line 11a, are governed by the velocity profile of the stages (mask support MT and substrate support WT) and the control metric. Both trajectories, and emphasized by the insets of Figure 6B, demonstrate that the shape of the opening 30 (i.e., slit shape) is not constant during an exposure period while the stages follow a non-constant velocity profile, for example, a sinusoidal velocity profile. Moreover, though the first blade 11 and the second blade 10 are designed to remove (or block) energy from both sides of the slit symmetrically based on field position, due to the non-linear movement of the mask support MT and the substrate support WT the slit becomes asymmetric.

As said the position or trajectory of each Y-blade 10, 11 depends on the velocity profile of the stages (the mask support MT and the substrate support WT), according to an embodiment of the invention, as illustrated by Figure 6B. According to a common approach, the position or trajectory of each blades is independent of the stage velocities, as is illustrated by Figure 4. By comparing both illustrations, a clear difference in the blade trajectories between the common approach (Figure 4) and current invention (Figure 6B) is observed.

According to an embodiment of the invention, there is provided a method for controlling an exposure dose at a substrate W utilizing a masking device MD, comprising a first blade 11 and a second blade 10, the method comprising: providing radiation pulses at the masking device MD for exposing the substrate W through a scanning slit; exposing an exposure area at the substrate W by moving the first blade 11 and the second blade 10 independent from each other; keeping an amount of radiation received at the exposed area constant; and wherein the first and second blade move in dependence of a velocity profile of a substrate support WT supporting the substrate W.

Keeping the amount of radiation received at the exposed area constant may be controlled and obtained by keeping the number of pulses in the slit (Nₛₗᵢₜ) constant. A controller 103 may be arranged that controls the blade positions as a function of Nₛₗᵢₜ and the mask support velocity V_{MT} and/or the substrate support velocity V_{WT}. In this arrangement Nₛₗᵢₜ is set as a control metric.

The dose accuracy scales with 1/sqrt(Nₛₗᵢₜ), due to pulse-to-pulse stochastics. Therefore, it is desirable to keep Nₛₗᵢₜ constant.

According to another arrangement, the amount of radiation received at the exposed area constant may be controlled and obtained by keeping the radiation dose constant. A controller 103 may be arranged that controls the blade positions as a function of radiation dose and the mask support velocity V_{MT} and/or the substrate support velocity V_{WT}. In this arrangement radiation dose is set as a control metric.

According to an embodiment of the invention, the velocity profile of the substrate support WT comprises (at least) a non-constant velocity during the exposure of the substrate. The velocity profile comprises a (at least partially) sinusoidal velocity profile.

According to a further embodiment of the invention, the first blade 10 moves in a first direction with respect to a center of the scanning slit and the second blade 11 moves in a second direction, the second direction being opposite to the first direction.

Although Nₛₗᵢₜ and dose may be used as control metrics, it may be advantageous to control the exposure dose at an exposure area by modulating the radiation source SR in response to the stage velocities as an additional control parameter. Thus, the exposure dose is not solely controlled by the Y-blade positions, but also by controlling the output of the radiation source SR. The output of the radiation source SR may therefore vary in pulse repetition rate, number of pulses, and/or intensity. By this additional control parameter, an optimized control can be achieved as well as a more flexible control method.

According to an embodiment of the invention, there is provided a controller (or control unit) 103 that is operable to perform the method of controlling an exposure dose at a substrate W, as disclosed above. The controller may receive one or more signals (or information) during an exposure cycle, wherein the one or more signals comprise information of mask support velocity V_{MT}, substrate support velocity V_{WT}, radiation dose, radiation pulse characteristics (e.g., pulse length, pulse energy, pulse repetition rate), position of masking blades, position of mask support MT, position of substrate support WT. The one or more signals may be provided by sensors or detectors.

The controller may comprise means to set and adjust the position of the masking blades in response to the received one or more signals (information). The adjustment of the blades may be done by actuators, which are controlled by the controller 103. The controller 103 may be part of or arranged at the masking device MD

It will be appreciated by the skilled person that the positions of the X-blades 20, 21 may be controlled by the control unit (controller) 103 in response to the input signals. Though, the position of the X-blades 20, 21 may be unchanged during the exposure of the substrate W.

The controller may comprise means to set and adjust the radiation pulse characteristics (e.g., pulse length, pulse energy, pulse repetition rate) of the radiation source SR.

According to an embodiment of the invention, there is provided a lithographic apparatus LA arranged to expose semiconductor substrates by means of radiation. The lithographic apparatus comprises an illuminator IL, a masking device MD, a mask support, a projection system PL, a substrate support WT. Furthermore, the lithographic apparatus LA may comprise a controller configured to control an exposure dose at a substrate W.

One or more detectors and/or sensors may be arranged in the lithographic apparatus LA to provide one or more signals to the controller. The one or more signals, as may be provided by the one or more detectors and or sensors, comprise information of mask support velocity V_{MT}, substrate support velocity V_{WT}, radiation dose, radiation pulse characteristics (e.g., pulse length, pulse energy, pulse repetition rate), position of masking blades, position of mask support MT, position of substrate support WT. One or more detectors and/or sensors may be arranged at the masking device MD, for example, to measure the positions of the blades as well as their velocities.

It will be appreciated by the skilled person that features of different aspects of the invention, as disclosed above, may be combined together.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Aspects of the invention are set out in the clauses below.
1. A method for controlling an exposure dose at a substrate utilizing a masking device, comprising a first blade and a second blade, the method comprising: providing radiation pulses at the masking device for exposing the substrate; exposing an exposure area at the substrate by moving the first blade in a first direction relative to a slit center and by moving the second blade in a second direction, the second direction being opposite to the first direction; keeping an amount of radiation received at the exposure area constant; and wherein moving the first and second blade is defined by a velocity profile of a substrate support supporting the substrate.
2. The method according to clause 1, wherein the velocity profile comprises a non-constant velocity of the substrate support.
3. The method according to clause 1 or 2, wherein the velocity profile comprises a sinusoidal velocity profile.
4. The method according to any of clauses 1 to 3, wherein the amount of radiation is controlled by an exposure control metric.
5. The method according to clause 4, wherein the exposure control metric is Nslit or dose.
6. A control unit comprising means to set positions of masking blades arranged in a masking device, wherein the control unit is operable to perform the method of controlling an exposure dose according to any of clauses 1 to 5.
7. The control unit according to clause 6, further comprising means to set and adjust radiation (pulse) characteristics of a radiation source being used during the exposure of the substrate.
8. A masking device for selectively shielding parts of a patterning device from a radiation beam, comprising: a plurality of masking blades being mechanically uncoupled with respect to one another; a control unit arranged to control a position of each of the plurality of masking blades; and wherein
   the position of at least two of the plurality of masing blades is defined by a velocity profile of a substrate support supporting a substrate.
9. The masking device according to clause 8, wherein the velocity profile comprises a non-constant velocity.
10. The masking device according to clause 8 or 9, wherein the velocity profile comprises a sinusoidal velocity profile.
11. An illumination system comprising the masking device according to any of clauses 8 to 10.
12. An exposure apparatus (or lithographic apparatus) comprising the illumination system according to clause 11.
13. A method for controlling masking blade positions of a masking device, comprising: receiving a first input at a control unit, the first input comprising information of a velocity profile of a mask support and/or substrate support to be used during an exposure; receiving a second input at the control unit, the second input being an exposure control metric; determining position set-points of masking blades during the exposure; and moving the masking blades to the determined position set-points.
14. The method according to clause 13, wherein the exposure control metric is Nslit or dose.
15. The method according to clause 13 or 14, further comprising receiving a masking blade position signal at the control unit being used as a feedforward or a feedback signal.
16. The method according to any of clauses 13 to 15, wherein moving the masking blades is performed by instructing one or more actuators connected to the masking blades.
17. A controller arranged to control positions of masking blades as a function of Nₛₗᵢₜ and the mask support velocity and/or the substrate support velocity, wherein Nₛₗᵢₜ is a control metric.
18. A controller arranged to control positions of masking blades as a function of radiation dose and the mask support velocity and/or the substrate support velocity, wherein radiation dose is a control metric.
19. The controller according to clause 17 or 18, wherein the velocity profile of the substrate support comprises at least a non-constant velocity during an exposure of a substrate.
20. The controller according to clause 19, wherein the velocity profile comprises a at least partially sinusoidal velocity profile.
21. The exposure apparatus according to clause 12, being a lithographic apparatus, further comprising a mask support, a projection system, and a substrate support.
22. The exposure apparatus according to clause 12 or 21, comprising one or more detectors to provide one or more signals to the control unit.
23. The exposure apparatus according to clause 22, wherein the one or more signals, provided by the one or more detectors, comprise information of mask support velocity, substrate support velocity, radiation dose, radiation pulse characteristics, position of masking blades, position of mask support, or position of substrate support.
24. The controller according to any of clauses 17 to 20, further comprising means to set and adjust radiation characteristics of a radiation source.
25. The method according to any of clauses 1 to 5, further comprising controlling the output of a radiation source that provides the radiation pulses.
26. The method according to any of clauses 1 to 5 and 25, further comprising adjusting radiation characteristics of a/the radiation source.
27. The masking device according to any of clauses 8 to 12, 21 and 22, further comprising actuators to move the plurality of blades.
28. The masking device according to any of clauses 8 to 12, 21, 22 and 27, further comprising one or more detectors for measuring the masking blade positions and/or velocities.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for controlling an exposure dose at a substrate utilizing a masking device, comprising a first blade and a second blade, the method comprising:
providing radiation pulses at the masking device for exposing the substrate;
exposing an exposure area at the substrate by
moving the first blade in a first direction relative to a slit center and by
moving the second blade in a second direction, the second direction being opposite to the first direction;
keeping an amount of radiation received at the exposure area constant; and
wherein moving the first and second blade is defined by a velocity profile of a substrate support supporting the substrate.

2. The method according to claim 1, wherein the velocity profile comprises a non-constant velocity of the substrate support.

3. The method according to claim 1 or 2, wherein the velocity profile comprises a sinusoidal velocity profile.

4. The method according to any of claims 1 to 3, wherein the amount of radiation is controlled by an exposure control metric.

5. The method according to claim 4, wherein the exposure control metric is Nₛₗᵢₜ or radiation dose.

6. A control unit comprising means to set positions of masking blades arranged in a masking device, wherein the control unit is operable to perform the method of controlling an exposure dose according to any of claims 1 to 5.

7. The control unit according to claim 6, further comprising means to set and adjust radiation characteristics of a radiation source being used during the exposure of the substrate.

8. A masking device for selectively shielding parts of a patterning device from a radiation beam, comprising:
a plurality of masking blades being mechanically uncoupled with respect to one another; and
a control unit arranged to control a position of each of the plurality of masking blades; wherein the position of at least two of the plurality of masing blades is defined by a velocity profile of a substrate support, the velocity profile being provided to the control unit.

9. The masking device according to claim 8, wherein the velocity profile comprises a non-constant velocity.

10. The masking device according to claim 8 or 9, wherein the velocity profile comprises a sinusoidal velocity profile.

11. An illumination system comprising the masking device according to any of claims 8 to 10.

12. An exposure apparatus comprising the illumination system according to claim 11.

13. A method for controlling masking blade positions of a masking device, comprising:
receiving a first input at a control unit, the first input comprising information of a velocity profile of a mask support and/or substrate support to be used during an exposure of a substrate;
receiving a second input at the control unit, the second input being an exposure control metric;
determining position set-points of masking blades during the exposure; and
moving the masking blades to the determined position set-points.

14. The method according to claim 13, wherein the exposure control metric is Nₛₗᵢₜ or radiation dose.

15. The method according to claim 13 or 14, further comprising receiving a masking blade position signal at the control unit being used as a feedforward or a feedback signal.
